# EUROPEAN PATENT APPLICATION

(11) **EP 2 015 365 A2**
(43) Date of publication of application: **14.01.2009**
(21) Application number: 08101840.0
(22) Date of filing: 21.02.2008
(51) Int. Cl.: H01L 31/0224, H01L 31/18

(54) **Solar cell with a transparent electrode and method of manufacturing the same**

(30) Priority: 13.07.2007 KR 20070070681
(71) Applicant: Samsung SDI Co., Ltd., Suwon-si, Gyeonggi-do (KR)
(72) Inventor: Moon, In-Sik, Gyeonggi-do (KR); Kim, Dae-Won, Gyeonggi-do (KR)
(74) Representative: Perkins, Dawn Elizabeth

(57) **Abstract**

A solar cell having a high photoelectric efficiency by minimizing (or reducing) electron transfer resistance and electrode shading loss. The solar cell includes a semiconductor substrate; an emitter layer on a first side of the semiconductor substrate; a conductive transparent electrode layer on the emitter layer; a first electrode on the conductive transparent electrode layer and electrically connected to the conductive transparent electrode layer; and a second electrode on a second side of the semiconductor substrate and electrically connected to the semiconductor substrate. The conductive transparent electrode layer has a specific resistance of about 500µΩ·cm or less. The emitter layer may be doped with a low concentration of impurities resulting in improve optical response at a short wavelength and minimization (or reduction) of recombination loss.

## Description

The present invention relates to a solar cell and a method of manufacturing the same. A solar cell generates electricity when an electron is moved to an n-type semiconductor due to an electric field generated from p-n junctions and a hole is moved to a p-type semiconductor. The electron and the hole are produced inside the semiconductors from energy provided by external light.

A solar cell can be fabricated as a crystalline silicon solar cell that includes a thin monocrystalline, polycrystalline, and polycrystalline membrane. However, this type of solar cell has a problem in that defects on the surface of and inside the silicon act as recombination centers for electron and hole pairs produced by external light, resulting in deterioration of photoelectric efficiency.

The silicon defects can be passivated by forming a thermal oxidation layer on the surface. Herein, the thermal oxidation layer can also play a role of an anti-reflection film. As such, various anti-reflection films and passivation layers have been formed by using a thermal oxidation layer.

A silicon nitride layer, a thin polycrystalline silicon layer, and a thin titanium oxide (TiO₂) layer for anti-reflection and ultraviolet ray-blocking effects can be added after a thermal oxidation layer has been formed.

Recently, as polycrystalline silicon solar cells have become popular, a silicon nitride layer has been developed and used. When the silicon nitride layer is disposed with a plasma enhanced chemical vapor deposition (PECVD) method, it not only works as an ideal anti-reflection film having a refractive index ranging from 1.9 to 2.3, but also passivates internal defects, interface defects, and surface defects of a polycrystalline silicon grain by using a large amount of hydrogen included therein. However, the passivation effect on the surface of the silicon nitride layer is less than that of a thermal oxidation layer.

The passivation effect is reported to be accomplished by a heterojunction with intrinsic thin layer (HIT) structure (hereinafter also referred to as HIT) that includes intrinsic a-Si at a thickness of less than 10nm on an n-type monocrystalline silicon (c-Si) substrate, and a p-type a-Si layer formed thereon to improve photoelectric efficiency in a solar cell. This HIT structure has p-n heterojunctions between n-type monocrystalline silicon and p-type amorphous silicon. There are many defects on the interface of p-n hetero junctions, which recombine electron and hole pairs produced by light. Here, the thin intrinsic amorphous silicon membrane in an HIT structure is inserted between p-n heterojunctions and passivates defects on the interface thereof to improve photoelectric efficiency.

However, most commercially-available solar cells have p-n homojunctions formed by diffusing n-type impurities on a p-type crystalline silicon substrate.

Aspects of embodiments of the present invention is directed toward a solar cell having a high photoelectric efficiency by minimizing (or reducing) electron transfer resistance and electrode shading loss, and a method of manufacturing the same.
An aspect of an embodiment of the present invention is directed toward a solar cell having a high photoelectric efficiency by minimizing (or reducing) electron transfer resistance and electrode shading loss.

An aspect of an embodiment of the present invention is directed toward a method of manufacturing the solar cell.

According to an embodiment of the present invention, a solar cell includes a semiconductor substrate; an emitter layer on a first side of the semiconductor substrate; a conductive transparent electrode layer on the emitter layer; a first electrode on the conductive transparent electrode layer and electrically connected to the conductive transparent electrode layer; and a second electrode on a second side of the semiconductor substrate and electrically connected to the semiconductor substrate. The conductive transparent electrode layer has a specific resistance of about 500µΩ ·cm or less.

The specific resistance of the conductive transparent electrode layer may be lower than that of the emitter layer.

The conductive transparent electrode layer may have a transmission rate of about 90% or more for a wavelength ranging from about 350 to about 800nm.

The conductive transparent electrode layer may have a refractive index ranging from about 1.7 to about 2.5.

The conductive transparent electrode layer may have a thickness ranging from about 60 to about 100nm.

The conductive transparent electrode layer may include a material selected from the group consisting of indium tin oxide (ITO), tin oxide, AgO, ZnO-(Ga₂O₃ or Al₂O₃), fluorine tin oxide (FTO), and mixtures thereof.

The first electrode may include a plurality of first electrodes spaced apart by an interval ranging from about 2.5 to about 8mm from each other.

The first electrode may include a material selected from the group consisting of Al, Ag, Ni, Cu, Ti, Pd, Cr, W, a conductive polymer, and combinations thereof.

The second electrode may include a material selected from the group consisting of Al, Ag, Ni, Cu, Ti, Pd, Cr, W, a conductive polymer, and combinations thereof.

The semiconductor substrate may be a p-type silicon substrate.

The semiconductor substrate may have a specific resistance ranging from about 0.5 to about 3Ω ·cm.

The emitter layer may be an n-type silicon substrate.

The emitter layer may have a surface resistance of about 50ohms per square(Ω/□) or more.

According to another embodiment of the present invention, a method of manufacturing a solar cell is provided. The method includes forming an emitter layer on a first side of a semiconductor substrate; forming a conductive transparent electrode layer on the emitter layer; forming a first electrode electrically connected to the conductive transparent electrode layer on the conductive transparent electrode layer; and forming a second electrode on a second side of the semiconductor substrate.

The semiconductor substrate may be a p-type silicon substrate.

The semiconductor substrate may have a specific resistance ranging from about 0.5 to about 3Ω ·cm.

The emitter layer may have an n-type silicon substrate.

The emitter layer may have a surface resistance of about 50Ω/□ or more.

The specific resistance of the conductive transparent electrode layer may be lower than that of the emitter layer.

The conductive transparent electrode layer may have a specific resistance of about 500µΩ ·cm or less.

The conductive transparent electrode layer may have a transmission rate of about 90% or more for a wavelength ranging from about 350 to about 800nm.

The conductive transparent electrode layer may have a refractive index ranging from about 1.7 to about 2.5.

The conductive transparent electrode layer may have a thickness ranging from about 60 to about 100nm.

The conductive transparent electrode layer may include a material selected from the group consisting of indium tin oxide (ITO), tin oxide, AgO, ZnO-(Ga₂O₃ or Al₂O₃), fluorine tin oxide (FTO), and mixtures thereof.

The first electrode may include a plurality of first electrodes spaced apart by an interval ranging from about 2.5 to about 8mm from each other.

The first electrode may include a material selected from the group consisting of Al, Ag, Ni, Cu, Ti, Pd, Cr, W, a conductive polymer, and combinations thereof.

The second electrode may include a material selected from the group consisting of Al, Ag, Ni, Cu, Ti, Pd, Cr, W, a conductive polymer, and combinations thereof.

The accompanying drawings, together with the specification, illustrate exemplary embodiments of the present invention, and, together with the description, serve to explain the principles of the present invention.

Figure 1 is a partial cross-sectional schematic view of a solar cell according to an embodiment of the present invention.

Figure 2 is a flow chart schematically showing a process of manufacturing a solar cell according to an embodiment of the present invention.

In the following detailed description, only certain exemplary embodiments of the present invention are shown and described, by way of illustration. As those skilled in the art would recognize, the invention may be embodied in many different forms and should not be construed as being limited to the embodiments set forth herein. Also, in the context of the present application, when an element is referred to as being "on" another element, it can be directly on the another element or be indirectly on the another element with one or more intervening elements interposed therebetween. Like reference numerals designate like elements throughout the specification.

In a conventional solar cell, electrodes are disposed in the front of an emitter layer doped with impurities, and thus electrons are transferred to the emitter layer and collected in the electrodes. When the electrons are transferred to the electrodes, some electrons may be lost. Thus, in order to reduce the electron loss, the emitter layer should be doped with a high concentration of impurities to lessen its resistance, or in order to reduce the electron loss due to the transfer, intervals between the electrodes can be shorten to a range from about 1.5 mm to about 2 mm.

However, when the amount of doped impurities in the emitter layer increases, an optical response at a short wavelength may be deteriorated or a recombination loss may increase. When the interval between the electrodes is short, a problem may occur in that the overall electrode area increases, so light shading loss due to the increased electrode area becomes large.

According to an embodiment of the present invention, a conductive transparent electrode layer having low resistance is disposed between the emitter layer and the electrodes, and thereby electrons are transferred through the conductive transparent electrode layer instead of the doped emitter layer. As such, resistance loss can be reduced or minimized and light shading loss can be reduced since electrode intervals may be increased.

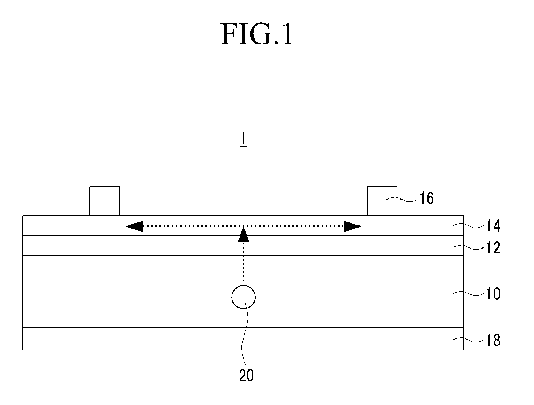

Figure 1 is a partial cross-sectional schematic view of a solar cell 1 according to an embodiment of the present invention.

Referring to Figure 1, the solar cell 1 includes a semiconductor substrate 10; an emitter layer 12 disposed on a first (or front) side of the semiconductor substrate 10; a conductive transparent electrode layer 14 disposed on the emitter layer 12; a first electrode 16 disposed on the conductive transparent electrode layer 14 and electrically connected to the conductive transparent electrode layer 14; and a second electrode 18 disposed on a second (or rear) side of the semiconductor substrate 10 and electrically connected to the semiconductor substrate 10.

The semiconductor substrate 10 is a p-type silicon substrate doped with impurities of Group 3 elements such as B, Ga, Al, etc.

The semiconductor substrate 10 can have various suitable concentrations of carriers (electrons or holes) produced by absorbing light depending on various specific resistances (doping concentration of impurities). In addition, the doping concentration also has an influence on recombination in which a carrier is not collected but is lost. Accordingly, when a semiconductor substrate is doped with impurities in a high concentration and thereby has small specific resistance, carriers produced by light absorption may have increased concentration and increased recombination, while when a semiconductor substrate is doped with impurities in a low concentration and thereby has large specific resistance, carriers produced by light absorption may have reduced concentration and decreased recombination. In other words, there is a trade-off between production of carriers and their loss due to recombination.

Considering the relationship of production of carriers and recombination loss of the carriers, a semiconductor substrate 10 doped with Group 3 elements may have specific resistance ranging from about 0.5 to about 3Ω ·cm (or from 0.5 to 3Ω ·cm). When a semiconductor substrate has specific resistance of less than 0.5Ω ·cm, carriers produced by light absorption may have an increased concentration, but the recombination loss may be too high. By contrast, when a semiconductor substrate has specific resistance of more than 3Ω ·cm, a carrier produced by light absorption may have too low of a concentration even if recombination loss is lower. According to embodiments of the present invention, when a semiconductor substrate has specific resistance of 0.5Ω ·cm, 1Ω ·cm, 1.5Ω ·cm, 2Ω ·cm, 2.5Ω ·cm, or 3Ω ·cm, recombination loss may be sufficiently reduce, thereby resulting in a high photoelectric efficiency of a cell.

The emitter layer 12 is an n-type silicon substrate doped with impurities of Groups 5 elements such as P, As, Sb, etc.

In addition, the semiconductor substrate 10 can be made of an n-type silicon substrate doped with P of Group 5. The emitter layer 12 may include a p-type silicon substrate doped with Group 3 elements.

Here, the semiconductor substrate 10 and the emitter layer 12 are doped by using a thermal diffusion process. This thermal diffusion contributes to fabrication of the semiconductor substrate 10 and the emitter layer 12 having a high doping concentration on the surface but progressively less concentration deeper inside the semiconductor substrate 10 and the emitter layer 12. The doping concentration profile can be generally measured by using secondary ion mass spectrometry (SIMS), but this takes a large amount of time and requires complicated analysis. Accordingly, the doping degree including doping concentration and depth can be evaluated by measuring surface resistance. The surface resistance has a decreasing value as doping becomes deeper with a higher concentration.

Accordingly, the emitter layer 12 may appropriately have surface resistance of about 50Ω/□ or more (or not less than 50Ω/□) after doping the impurity. When the emitter layer 12 has surface resistance of less than 50 Ω/□, that is, a high doping concentration on the surface and deeper doping, it may have more loss due to recombination of a carrier excited by light. In addition, considering reduced photoelectric efficiency of a cell according to deteriorated separation capability of a carrier, an emitter layer may have surface resistance ranging from 50 to 300Ω/□. However, according to another embodiment of the present invention, it may have surface resistance ranging from 50 to 150Ω/□ to reduce optical reflection loss due to decreased separation capability of a carrier and decreased area of a first electrode. When the emitter layer 12 has surface resistance of 50Ω/□, 80Ω/□, 100Ω/□, 150Ω/□, 200Ω/□, or 300Ω/□ after doping impurities, it may have reduced recombination loss of carriers exited by light, thereby resulting in a high photoelectric efficiency of a cell.

The semiconductor substrate 10 contacts the emitter layer 12 and thereby forms p-n junctions.

The emitter layer 12 includes a conductive transparent electrode layer 14 with low resistance thereon.

The conductive transparent electrode layer 14 can be a passage for electrons and an anti-reflection film in a solar cell. In particular, the conductive transparent electrode layer 14 may have specific resistance of less than about 500µΩ ·cm (when it is 100nm thick) or not greater than 500µΩ ·cm (when it is 100nm thick). However, it can have specific resistance ranging from 100 to 500µΩ ·cm according to another embodiment of the present invention. When the conductive transparent electrode layer 14 has specific resistance of more than 500µΩ ·cm, it may have a large loss during movement of electrons. According to an embodiment of the present invention, when the conductive transparent electrode layer 14 has specific resistance of 100µΩ ·cm, 150µΩ ·cm, 200µΩ ·cm, 250µΩ ·cm, 300µΩ ·cm, 350µΩ ·cm, 400µΩ ·cm, 450µΩ ·cm, or 500µΩ ·cm, it may have reduced loss during movement of electrons, thereby resulting in a high photoelectric efficiency of a cell.

In addition, the conductive transparent electrode layer 14 may have a lower specific resistance ( 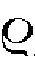 ) than that of the emitter layer 12.

Furthermore, the conductive transparent electrode layer 14 may have a transmission rate of more than about 90% (or not less than 90%) for a wavelength ranging from about 350 to about 800nm (or from 350 to 800nm). However, according to another embodiment, it may have a transmission rate ranging from 90 to 99% for the wavelength ranging from about 350 to about 800nm (or from 350 to 800nm). When a conductive transparent electrode layer 14 has a transmission rate of less than 90% for the wavelength ranging from about 350 to about 800nm (or from 350 to 800nm), it may have a decreased amount of incident light. When the conductive transparent electrode layer 14 has a transmission rate of 90%, 92%, 94%, 96%, 98%, or 99% for the wavelength ranging from about 350 to about 800nm (or from 350 to 800nm), it may have an increased amount of incident light, thereby resulting in a high photoelectric efficiency of a cell.

The conductive transparent electrode layer 14 can be a passage for electrons, and also as an anti-reflection film.

Accordingly, it may have the same (or substantially the same) properties as required for a conventional anti-reflection film. In general, an anti-reflection film should simultaneously minimize (or reduce) reflection loss and recombination loss on the surface of a substrate. Accordingly, it may have a low absorption rate and refractive index, but a high transmission rate to minimize (or reduce) reflection loss. In addition, to minimize (or reduce) recombination loss on the surface, an anti-reflection film should have suitable refractive index, absorption yield, and surface passivation characteristics.

Considering these requirements for an anti-reflection film, the conductive transparent electrode layer 14 may have a refractive index ranging from about 1.7 to about 2.5 (or from 1.7 to 2.5). When a conductive transparent electrode layer 14 has a refractive index that is not within the above described range, it may cause a large reflection loss. On the contrary, when a conductive transparent electrode layer 14 has a refractive index of 1.7, 1.8, 1.9, 2.0, 2.1, 2.2, 2.3, 2.4, or 2.5, it may have a decreased reflection loss, thereby resulting in a high photoelectric efficiency of a cell.

The conductive transparent electrode layer 14 may have various suitable thicknesses depending on its refractive index. Accordingly, considering the refractive index range, the conductive transparent electrode layer 14 may have a thickness ranging from about 60 to about 100nm (or from 60 to 100nm). When a conductive transparent electrode layer 14 is prepared to be out of the thickness range, it may cause a reflection loss. According to the embodiment of the present invention, when the conductive transparent electrode layer 14 has a thickness of 60nm, 70nm, 80nm, 90nm, or 100nm, it may have a reduced reflection loss, thereby resulting in a high photoelectric efficiency of a cell.

In one embodiment, the conductive transparent electrode layer 14 has a suitable refractive index and a suitable transmission rate for minimizing (or reducing) reflection loss. When the layer is complete, its reflection loss can be calculated by measuring its reflection rate. On the other hand, ultraviolet rays of the sun have a wavelength ranging from hundreds of nanometers to micrometers, while a silicon solar cell uses a wavelength ranging from 300 to 1100nm thereof.

The conductive transparent electrode layer 14 may have various suitable refractive indexes depending on light wavelengths. When a conductive transparent electrode layer has a particular refractive index at a particular wavelength, the thickness of the conductive transparent electrode layer 14 determines a suitable (or minimum) reflection rate at the wavelength. Accordingly, when a conductive transparent electrode layer 14 has a refractive index of 1.9 at a wavelength of 550nm where the sunlight is strongest, it may have a thickness of 90nm. On the other hand, when it has a refractive index of 2.3, it may have a thickness of 65nm. When a conductive transparent electrode layer 14 with a refractive index of 2.3 and a thickness of 65nm was measured regarding reflection rate, it was found to have a minimum reflection rate at around the wavelength of 550nm. The reflection rate became smaller as the wavelength became shorter or longer, thereby resulting a bell-shaped curve (or graph).

According to one embodiment of the present invention, a conductive transparent electrode layer 14 has no particular limit as long as it is transparent and conductive. In particular, the conductive transparent electrode layer 14 may be formed from a material selected from the group consisting of indium tin oxide (ITO), a tin-based oxide (SnO₂ and the like), AgO, ZnO-(Ga₂O₃ or Al₂O₃), fluorine tin oxide (FTO), and mixtures thereof.

First electrodes 16 are disposed on the conductive transparent electrode layer 14.

The first electrodes 16 are electrically connected to the conductive transparent electrode layer 14 and disposed as a plurality of electrode parts with a particular distance therebetween.

The disposition distance between the first electrodes 16 should be determined based on a trade-off relationship between resistance loss according to specific resistance of the conductive transparent electrode layer 14 and optical reflection loss due to electrode area. In other words, when the first electrodes 16 are disposed with a large distance therebetween, they may have a smaller area in total, thereby decreasing optical reflection loss.

Accordingly, the first electrodes 16 may be disposed with a distance ranging from about 2.5 to about 8mm (or from 2.5 to 8mm) therebetween. When the first electrodes 16 are disposed with a distance of less than 2.5mm therebetween, they may have an increased total area and thereby cause electrode shading loss. On the contrary, when they are disposed with a distance of more than 8mm therebetween, they may have a greater increase in resistance loss than a decrease in optical reflection as electrons need to move farther. According to embodiments of the present invention, the first electrodes are disposed with a distance of 2.5mm, 3mm, 4mm, 5mm, 6mm, 7mm, or 8mm therebetween, and thereby have decreased electrode shading loss, thereby resulting in a high photoelectric efficiency of a cell. In particular, when a conductive transparent electrode layer 14 has specific resistance of 100µΩ ·cm, the first electrodes may be disposed with a distance ranging from 2.5 to 6mm therebetween.

Each first electrode 16 may be formed from a material selected from the group consisting of Al, Ag, Ni, Cu, Ti, Pd, Cr, W, a conductive polymer, and combinations thereof.

The material for forming one of the first electrodes 16 may be appropriately selected depending on its fabrication method. In one embodiment, when screen printing is adopted, the first electrode 16 is prepared by using a material selected from the group consisting of Ag, Al, and combinations thereof. On the other hand, when an ink jet or dispensing method is adopted, the first electrode 16 may be prepared by using a material selected from the group consisting of Ni, Ag, and combinations thereof. In addition, when a plating method is adopted, the first electrode 16 is prepared by using a material selected from the group consisting of Ni, Cu, Ag, and combinations thereof, while when a deposition method is adopted, the first electrode 16 may be prepared by using a material selected from the group consisting of Al, Ni, Cu, Ag, Ti, Pd, Cr, W, and combinations thereof. Furthermore, when the first electrode 16 is prepared by firing at a low temperature, the first electrode 16 may include a mixture of Ag and a conductive polymer.

A second electrode 18 is disposed on the back of the semiconductor substrate 10 and electrically connected thereto.

The second electrode 18 may include the same (or substantially the same) material as the first electrodes 16.

When light enters p-n junctions of a solar cell 1 with the above structure, electrons and holes are generated inside the semiconductor of the solar cell 1 by the provided light energy. In general, when light of less than band gap energy enters the semiconductor, it interacts with electrons inside the semiconductor; while, when light of more than band gap energy enters the semiconductor, it excites electrons inside a covalent bond and thereby produces electrons 20 (or holes). The electrons 20 produced by the light energy move toward an emitter layer 12 made of an n-type semiconductor, and thereafter gather at a first electrode 16 through a conductive transparent electrode layer 14. The produced holes move toward the semiconductor substrate 10 made of a p-type semiconductor by an internal electric field, and gather at a second electrode 18. These first and second electrodes 16 and 18 are connected to each other through a wire, so that a current flows through them, thereby generating electric power.

A solar cell according to an embodiment of the present invention may be manufactured by the following method: forming an emitter layer on a first (or front) side of a semiconductor substrate; forming a conductive transparent electrode layer on the emitter layer; forming first electrodes electrically connected to the conductive transparent electrode layer on the conductive transparent electrode layer; and forming a second electrode on a second (or rear) side of the semiconductor substrate.

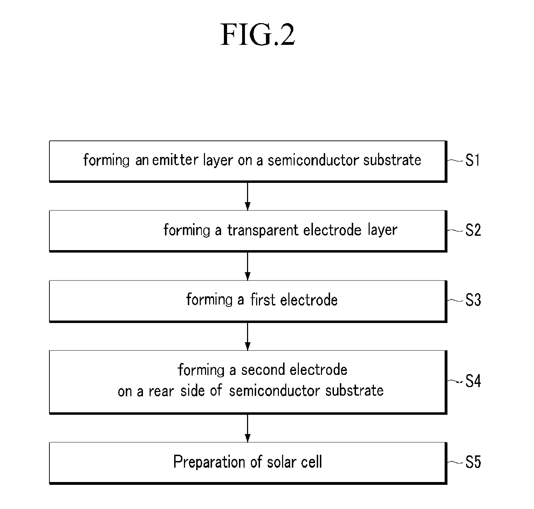

Figure 2 is a flow chart showing a process of manufacturing a solar cell according to an embodiment of the present invention. Referring to Figure 2, the method is described in more detail hereinafter. First, an emitter layer is formed on a semiconductor substrate or on a first side of the semiconductor substrate (S1).

The semiconductor substrate and the emitter layer are the same (or substantially the same) as described above with respect to Figure 1.

However, the semiconductor substrate can be pretreated with a process selected from the group consisting of a saw damage removal process, a texturing process by forming protrusions and depressions on the surface to reduce a surface reflection rate, and a substrate cleaning process before disposing the emitter layer on the semiconductor substrate.

The emitter layer can be formed on the semiconductor substrate with a suitable method, for example, with a high temperature diffusion method. Here, an oxidation film formed of phospho-silicate-glass (PSG) utilized in the case of P doping and disposed on the surface of the semiconductor substrate with a high temperature diffusion method may be removed by a chemical etching method.

Then, a conductive transparent electrode layer is disposed on the emitter layer (S2).

The conductive transparent electrode layer may be the same (or substantially the same) as aforementioned. The conductive transparent electrode can be formed by coating a paste for forming a conductive transparent electrode layer and then heat-treating it, or with a deposition method by sputtering, plating, and the like.

Here, the paste may have somewhat different properties depending on the coating method. The coating method may include ink-jet printing, dispensing, spraying, a doctor blade method, screen printing, or the like. In addition, the transparent film can be formed with a spin-coating or spraying method or any suitable wet-coating method.

When a paste used for the conductive transparent electrode layer includes a binder, a heat treatment after coating can be performed at a temperature ranging from 400 to 600°C for 30 minutes. On the contrary, when the paste does not include a binder, the heat treatment can be performed at a temperature of less than 200°C.

Next, a first electrode is formed on the conductive transparent electrode layer and electrically connected thereto (S3).

The first electrode is the same (or substantially the same) as aforementioned, and can be formed with a physical vapor deposition (PVD) method such as electroplating, sputtering, electron beam deposition, and the like. Alternatively, the first electrode can be performed by coating a paste including a conductive material as the first electrode and then sintering it.

In addition, p-n junctions are isolated in an edge-isolation (E/I) process. The edge-isolation (E/I) process is performed by using plasma after forming an emitter layer or by using a laser after forming a first electrode.

Then, a second electrode is disposed on a second (or back) side of the semiconductor substrate (S4).

The second electrode is also the same (or substantially the same) as aforementioned, and can be formed with the same (or substantially the same) method as the first electrode.

In the manufacturing method, the aforementioned processes can be changed in order or performed together. For example, formation of a conductive transparent electrode layer (S2) can be exchanged with formation of the second electrode (S4). In addition, a paste can be patterned first and then sintered.

According to the embodiment of the present invention, a solar cell is the prepared (S5). The solar cell according to the aforementioned method can minimize (or reduce) resistance against electron movement and electrode shading loss, and thereby has a high photoelectric efficiency. In addition, since an emitter layer can be doped with impurities at a low concentration, it can improve optical response characteristics and minimize (or reduce) recombination loss. Likewise, formation of the first electrode S3 can be exchanged with formation of a second electrode S4, or they can be simultaneously (or concurrently) formed.

The following examples illustrate the present invention in more detail. However, the present invention is not limited by these examples.

### Example 1

An emitter layer was disposed to be 0.45µm thick on one side of a boron-doped p-type silicon substrate (specific resistance: 1Ω ·cm) with phosphorus-doped n-type silicon. The boron was doped in an amount of 1.5X10¹⁶/cm³ on a p-type silicon substrate. The emitter layer including n-type silicon had a surface resistance of 50Ω/□.

Then, an 80nm-thick conductive transparent electrode layer was disposed on the emitter layer with a sputtering method.

An Al-containing paste was screen-printed on the other side of the p-type silicon substrate (i.e., on the side having no emitter layer). In addition, the p-type silicon substrate with the conductive transparent electrode layer was screen-printed with a Ag-containing paste every 6mm to form a pattern, and thereafter sintered at 400°C for 30 seconds to simultaneously (or concurrently) form first and second electrodes to thereby fabricate a solar cell.

The emitter layer in the corner of the solar cell was removed with a laser to separate it from the other side on the back of the substrate.

### Example 2

A 0.3µm-thick emitter layer was disposed with phosphorus-doped n-type silicon on one side of a boron-doped p-type silicon substrate (specific resistance: 1Ω ·cm). Here, the boron was doped in an amount of 1.5X10¹⁶/cm³ on the p-type silicon substrate. The emitter layer including n-type silicon had a surface resistance of 100Ω/□. Then, a conductive transparent electrode layer was disposed to be 80nm thick on the emitter layer by using indium tin oxide (ITO) with a sputtering method.

Further, an Al-containing paste was screen-printed on the other side of the p-type silicon substrate (i.e., on the side having no emitter layer). In addition, the p-type silicon substrate with the conductive transparent electrode layer was screen-printed with a Ag-containing paste every 2.5mm to form a pattern, and thereafter sintered at 400°C for 30 seconds to simultaneously (or concurrently) form first and second electrodes to thereby fabricate a solar cell.

The emitter layer in the corner of the solar cell was removed with a laser to separate it from the other side on the back of the substrate.

### Example 3

A 0.3µm thick phosphorus-doped n-type silicon emitter layer was disposed on one side of a boron-doped p-type silicon substrate (specific resistance: 1Ω ·cm). Here, the boron was doped in an amount of 1.5X10¹⁶/cm³ on the p-type silicon substrate. The emitter layer including n-type silicon had surface resistance of 100Ω/□.

Then, a conductive transparent electrode layer was disposed to be 80nm thick on the emitter layer by using indium tin oxide (ITO) with a sputtering method.

An Al-containing paste was screen-printed on the other side of the p-type silicon substrate (i.e., on the side having no emitter layer). In addition, the p-type silicon substrate with the conductive transparent electrode layer was screen-printed with an Ag-containing paste every 6mm to form a pattern, and thereafter, sintered at 400°C for 30 seconds to simultaneously (or concurrently) form first and second electrodes to finally fabricate a solar cell.

The emitter layer in the corner of the solar cell was removed with a laser to separate it from the other side on the back of the substrate.

### Example 4

A 0.3µm thick phosphorus-doped n-type silicon emitter layer was disposed on one side of a boron-doped p-type silicon substrate (specific resistance: 1Ω ·cm). Here, the boron was doped in an amount of 1.5X10¹⁶/cm³ on the p-type silicon substrate. The emitter layer including n-type silicon had surface resistance of 100Ω/□.

Then, a conductive transparent electrode layer was disposed to be 80nm thick on the emitter layer by using indium tin oxide (ITO) with a sputtering method.

An Al-containing paste was screen-printed on the other side of the p-type silicon substrate (i.e., on the side having no emitter layer). In addition, the p-type silicon substrate with the conductive transparent electrode layer was screen-printed with a Ag-containing paste at every 2.5mm intervals to form a pattern, and thereafter, sintered at 400°C for 30 seconds to simultaneously (or concurrently) form first and second electrodes to thereby fabricate a solar cell.

The emitter layer in the corner of the solar cell was removed with a laser to separate it from the other side on the back of the substrate.

### Example 5

A solar cell was fabricated according to the same (or substantially the same) method as in Example 4, except for disposing a 100nm-thick conductive transparent electrode layer with AZO (Al doped ZnO) as a material for a conductive transparent electrode layer with a sputtering method.

### Example 6

A solar cell was fabricated according to the same (or substantially the same) method as in Example 4, except for disposing a 100nm-thick conductive transparent electrode layer with SnO₂ by spin-coating a SnO₂-containing solution on the emitter layer and then heat-treating it at 700°C.

### Example 7

A solar cell was fabricated according to the same (or substantially the same) method as in Example 3, except for using FTO as a material for forming a conductive transparent electrode layer.

### Example 8

A solar cell was fabricated according to the same (or substantially the same) method as in Example 3, except for using AgO as a material for forming a conductive transparent electrode layer.

### Comparative Example 1

A 0.45µm thick phosphorus-doped n-type silicon emitter layer was disposed on one side of a boron-doped p-type silicon substrate (specific resistance: 1Ω ·cm). Here, the boron was doped in an amount of 1.5X10¹⁶/cm³ on the p-type silicon substrate. The emitter layer including n-type silicon had surface resistance of 50Ω/□.

Then, a 70nm-thick anti-reflection film was disposed on the emitter layer by using silicon nitride (SiNₓ) with a refractive index of 2.1 with a chemical vapor deposition method.

An Al-containing paste was screen-printed on the other side of the p-type silicon substrate (i.e., on the side having no emitter layer). In addition, the p-type silicon substrate with the conductive transparent electrode layer was screen-printed with a Ag-containing paste every 2.5mm to form a pattern, and thereafter, sintered at 400°C for 30 seconds to simultaneously (or concurrently) form first and second electrodes to thereby fabricate a solar cell.

The emitter layer in the corner of the solar cell was removed with a laser to separate it from the other side on the back of the substrate.

The solar cell conductive transparent electrode layers according to Examples 1 to 5 were measured regarding thickness, specific resistance, transmission rate, and refractive index. The results are shown in the following Table 1.

**Table 1**

| | Thickness (nm) | Specific resistance (µΩ ·cm) | Transmission rate (%, at 600nm) | Refractive index (at 600nm) |
|---|---|---|---|---|
| Example 1 | 80 | 150 | 95 | 1.9 |
| Example 2 | 80 | 150 | 95 | 1.9 |
| Example 3 | 80 | 150 | 95 | 1.9 |
| Example 4 | 100 | 140 | 95 | 1.8 |
| Example 5 | 100 | 452 | 92 | 1.9 |

Current (I)-voltage (V) characteristics of the solar cells according to Examples 1 to 3 and Comparative Example 1 were measured by radiating light of 100mW/cm² (AM 1.5G condition).

From the current-voltage characteristic graph, open voltage (VOC), short-circuit current density (JSC), fill factor (FF), and efficiency (ηW) of white light were evaluated and are presented in Table 2.

**Table 2**

| | V_{OC}[V] | J_{SC}[mA/cm²] | FF[%] | η[%] |
|---|---|---|---|---|
| Example 1 | 613 | 33.5 | 76.6 | 15.7 |
| Example 2 | 612 | 32.6 | 76.6 | 15.3 |
| Example 3 | 615 | 33.7 | 76.6 | 16.0 |
| Comparative Example 1 | 611 | 32.6 | 75.4 | 15.0 |

As a result of the measurements, the solar cells according to Examples 1 to 3 showed better open circuit voltage (VOC), short-circuit current density (JSC), fill factor (FF), and efficiency (ηW) of white light as compared to the solar cell of Comparative Example 1.

This is because the solar cell of Example 1 included widely-patterned electrodes and thereby had less optical reflection loss. The solar cell of Example 2 had increased surface resistance in the emitter layer, and thereby had less recombination loss of a carrier excited by light. The solar cell of Example 3 had both less optical reflection loss and less recombination loss of a carrier excited by light.

Accordingly, the solar cells of Examples 1 to 3 had better photoelectric efficiency as compared to that of Comparative Example 1.

Likewise, the solar cells of Examples 4 to 8 were measured regarding open circuit voltage (V_{OC}), short-circuit current density (J_{SC}), fill factor (FF), and efficiency (η) of white light according to the same (or substantially the same) method as aforementioned.

As a result, the solar cells according to Example 4 to 6 had equivalent values to that of Example 2 due to increased surface resistances in the emitter layers and reduced recombination loss of a carrier excited by light. The solar cells of Examples 7 and 8 had equivalent values to that of Example 3 due to reduced reflection loss and reduced recombination loss of a carrier excited by light.

Therefore, a solar cell of an embodiment of the present invention has a high photoelectric efficiency by minimizing (or reducing) electron transfer resistance and electrode shading loss. Here, the emitter layer may be doped with a low concentration of impurities, and thereby can improve an optical response at a short wavelength and minimize (or reduce) recombination loss.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

## Claims

1. A solar cell comprising:
a semiconductor substrate (10);
an emitter layer (12) on a first side of the semiconductor substrate (10);
a conductive transparent electrode layer (14) on the emitter layer (12);
a first electrode (16) on the conductive transparent electrode layer (12) and electrically connected to the conductive transparent electrode layer (14); and
a second electrode (18) on a second side of the semiconductor substrate (10) and electrically connected to the semiconductor substrate (10),
wherein the conductive transparent electrode layer (14) has a specific resistance of about 500µΩ ·cm or less.

2. The solar cell of claim 1, wherein the specific resistance of the conductive transparent electrode layer (14) is lower than that of the emitter layer (12).

3. The solar cell of claim 1 or 2, wherein the conductive transparent electrode layer (14) has a transmission rate of about 90% or more for a wavelength ranging from about 350 to about 800nm.

4. The solar cell of any one of the preceding claims, wherein the conductive transparent electrode layer (14) has a refractive index ranging from about 1.7 to about 2.5.

5. The solar cell of any one of the preceding claims, wherein the conductive transparent electrode layer (14) has a thickness ranging from about 60 to about 100nm.

6. The solar cell of any one of the preceding claims, wherein the conductive transparent electrode layer (14) comprises a material selected from the group consisting of indium tin oxide (ITO), tin oxide, AgO, ZnO-(Ga₂O₃ or Al₂O₃), fluorine tin oxide (FTO), and mixtures thereof.

7. The solar cell of any one of the preceding claims, wherein the first electrode (16) comprises a plurality of first electrodes spaced apart by an interval ranging from about 2.5 to about 8mm from each other.

8. The solar cell of any one of the preceding claims, wherein the first electrode (16) comprises a material selected from the group consisting of Al, Ag, Ni, Cu, Ti, Pd, Cr, W, a conductive polymer, and combinations thereof.

9. The solar cell of any one of the preceding claims, wherein the second electrode (18) comprises a material selected from the group consisting of Al, Ag, Ni, Cu, Ti, Pd, Cr, W, a conductive polymer, and combinations thereof.

10. The solar cell of any one of the preceding claims, wherein the semiconductor substrate (10) is a p-type silicon substrate.

11. The solar cell of any one of the preceding claims, wherein the semiconductor substrate (10) has a specific resistance ranging from about 0.5 to about 3Ω ·cm.

12. The solar cell of any one of the preceding claims, wherein the emitter layer (12) is an n-type silicon substrate.

13. The solar cell of any one of the preceding claims, wherein the emitter layer (12) has a surface resistance of about 50 ohms per square or more.

14. A method of manufacturing a solar cell, the method comprising:
forming an emitter layer (12) on a first side of a semiconductor substrate (10);
forming a conductive transparent electrode layer (14) on the emitter layer (12);
forming a first electrode (16) electrically connected to the conductive transparent electrode layer (14) on the conductive transparent electrode layer (14); and
forming a second electrode (18) on a second side of the semiconductor substrate (10).

15. The method of claim 14, wherein the semiconductor substrate (10) is a p-type silicon substrate.

16. The method of claim 14 or 15 wherein the emitter layer (12) is an n-type silicon substrate.

17. The method of any one of claims 14 to 16, wherein the conductive transparent electrode layer (14) has a thickness ranging from about 60 to about 100nm.

18. The method of any one of claims 14 to 17, wherein the conductive transparent electrode layer (14) comprises a material selected from the group consisting of indium tin oxide (ITO), tin oxide, AgO, ZnO-(Ga₂O₃ or Al₂O₃), fluorine tin oxide (FTO), and mixtures thereof.

19. The method of any one of claims 14 to 18, wherein the first electrode (16) comprises a plurality of first electrodes spaced apart by an interval ranging from about 2.5 to about 8mm from each other.
